# EUROPEAN PATENT APPLICATION

(11) **EP 4 498 099 A1**
(43) Date of publication of application: **29.01.2025**
(21) Application number: 24184282.2
(22) Date of filing: 25.06.2024
(51) Int. Cl.: G01R 21/133, G01D 4/00, G06Q 50/06

(54) **SYSTEM FOR MONITORING ENERGY CONSUMPTION**

(30) Priority: 26.07.2023 IT 202300015669
(71) Applicant: Helios Domotics s.r.l., 00013 Fonte Nuova (RM) (IT)
(72) Inventor: BOCCIARELLI, Cristian, 00141 ROMA (IT); ERCULIANI, Luca, 37012 BUSSOLENGO (VR) (IT)
(74) Representative: Bellomia, Paolo

(57) **Abstract**

Described is a system for monitoring energy consumption comprising a local terminal 1 and a remote terminal 2. The local terminal (1) is configured for acquiring information regarding the electrical power absorbed by an electrical user device (U). The remote terminal (2) is configured for disaggregating the information relating to the total power absorbed by the electrical user device (U) distinguishing the contributions given by the individual devices coupled to it.

## Description

This invention relates to the technical sector of systems for improving energy efficiency.

In particular, the invention relates to a system for monitoring the energy consumption which is used in particular in the home, in order to reduce the energy consumption and allow a more efficient management of the corresponding electrical user device.

There is a comprehensive academic literature on NILM (Non Intrusive Load Monitoring), that is to say, the set of technologies that are able to the identify loads by disaggregation on the measurement of an aggregate power consumption. There are some solutions which should allow the measurement of the consumption of domestic power in a non-invasive manner (that is to say, without significantly influencing the supply of voltage and current to the user); these solutions are, however, still not very efficient and not precise to date.

There are therefore no simple, precise, effective and non-invasive solutions.

Improving the precision of the measurement, making the disaggregation of the consumption more precise, increasing the spectrum of the recognised devices, achieving real-time recognition of the switching on and off of a device, making the user experience simple and intuitive, involving the user to maximise the savings, maintaining and, if necessary, improving the non-invasiveness of the solution are some of the improvements required for this type of technology, and which are still not available, in order to make it advantageously usable in a satisfactory manner for the users.

In this context, the technical purpose which forms the basis of this invention is to provide a system for monitoring energy consumption which overcomes at least some of the above-mentioned drawbacks of the prior art, dealing with the issues presented to provide a satisfactory solution.

In particular, the aim of this invention is to provide a system for monitoring energy consumption which is able to precisely recognise the individual devices connected to the user, in this way allowing a certain distinction to be made between the corresponding consumption and associating it with the respective devices.

The technical purpose indicated and the aims specified are substantially achieved by a system for monitoring energy consumption comprising the technical features described in one or more of the appended claims.

The invention describes a system for monitoring energy consumption.

This system basically comprises a local terminal and a remote terminal.

The local terminal comprises a first sensor, a second sensor and a microcontroller.

The first sensor is configured for measuring a total current dispensed to an electrical user device generating a current signal.

The second sensor is configured for measuring a total voltage dispensed to the user device generating a voltage signal.

The microcontroller is configured to control the activation of the sensors in such a way as to acquire current and voltage signals continuously over time. The microcontroller is further configured for calculating an active power signal of the electric user device as a function of the current and voltage signals.

The remote terminal is connectable to the local terminal to receive the active power signal.

The remote terminal comprises a database and a calculation unit.

The database configured for storing a plurality of energy footprints representing an absorption of electricity uniquely associated with respective devices.

The calculation unit is configured for processing the active power value identifying the power components absorbed by each device connected to the electrical user device as a function of the corresponding energy footprints. Advantageously, the system proposed makes it possible to acquire the information of interest and process it to provide the remote terminal with the values by which it is able to disaggregate the overall data identifying the consumptions associated with each individual device.

The dependent claims, incorporated herein for reference, relate to different embodiments of the invention.

Further features and advantages of this invention are more apparent in the nonlimiting description of a preferred but non-exclusive embodiment of a system for monitoring energy consumption, as illustrated in the accompanying drawings, in which:

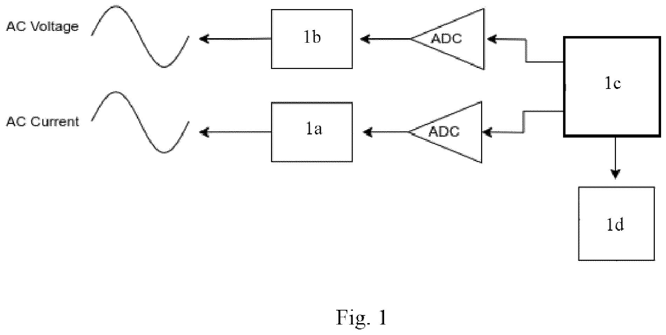

- Figure 1 shows one of the components of the system according to this invention;

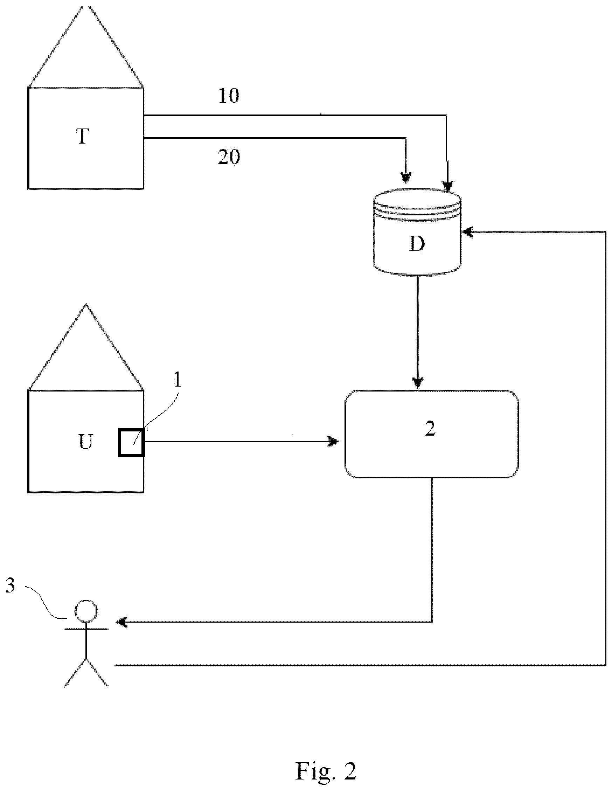

- Figure 2 shows a possible implementation condition of the system.

The system according to this invention is specifically configured to perform a continuous monitoring of the energy consumption of an electric user U, such as, for example, a domestic user, in such a way as to allow the user to easily and immediately control and verify the level of the consumption of each device connected to the user in order to receive electricity from it.

In this way it is possible to check the relative consumption and adopt, where necessary, measures aimed at reducing it with consequent economic savings and benefits also at an environmental level.

In terms of its components, the system basically comprises a local terminal 1 and a remote terminal 2.

The local terminal 1 is designed to acquire data by sampling the parameters of interest of the user, according to methods described in detail below.

The remote terminal 2 is, on the other hand, connected/connectable to the local terminal 1 and is designed for analysing the information collected by the latter in such a way as to determine the consumption of the individual devices connected to the user.

In more detail, the local terminal 1 comprises a first sensor 1a, a second sensor 1b and a microcontroller 1c.

The first sensor 1a is configured for measuring a total current dispensed to an electrical user device U generating a corresponding current signal and may preferably comprise or be defined by an amperometric gripper or by a Hall effect current sensor.

It should be noted that the expression "current signal" is used to indicate in general terms a signal which is able to provide information concerning the current being supplied at a given moment to the electrical user device U, without thereby implying that the signal is supplied/measured/processed directly as a set/sequence of current values.

More specifically, according to a preferred embodiment, the first sensor 1a is configured for converting the current signal of the electrical user U into a set/sequence of voltage values which can be digitised and supplied to the microcontroller 1c to perform the desired measurement.

The second sensor 1b is, on the other hand, configured for measuring a total voltage dispensed to the electrical user device U generating a voltage signal and may preferably comprise or be defined by a transformer for uncoupling and scaling the voltage.

Advantageously, the local terminal 1 may further comprise an analysis module configured for filtering and amplifying the current and voltage signals generated by the respective sensors 1a, 1b in such a way as to optimise the measurement process and improve the quality of the information which is acquired.

The microcontroller 1c is, on the other hand, configured to control the activation of the sensors 1a, 1b in such a way as to continuously acquire over time the current and voltage signals.

In particular, the microcontroller 1c controls the acquisition of thousands of samples per second for a total number of samples such as to cover a whole number of periods of the sinusoid of the AC voltage and current (for example, in Italy the frequency of the AC voltage is 50 Hz so a period has a duration of 20 ms).
the microcontroller 1c is further configured for calculating an active power signal, associated with the electric user device U, as a function of said current and voltage signals.

In order to obtain this result, the current and voltage signals are multiplied and the result is integrated to obtain the active power value.

These power values are transmitted to the remote terminal 2 by means of a suitable transmission module 1d (which in turn forms part of the local terminal 1) which may, for example, comprise a Wi-Fi^{®} antenna and therefore allow a communication between the local terminal 1 and the remote terminal 2 using a corresponding communication protocol.

The remote terminal 2 is therefore connectable with the local terminal 1 for receiving the active power signal and basically comprises a database and a calculation unit.
the database is configured for storing a plurality of energy footprints representing an absorption of electricity uniquely associated with respective devices.

In other words, data are stored on the database which identify a plurality of devices potentially connectable to the electrical user device U to be powered by it and to which a specific power absorption profile (the energy footprint) is uniquely associated in terms of frequencies, intensity, absorption periods or similar parameters.

These energy footprints therefore allow the corresponding device to be identified unequivocally on the basis of its specific methods for supplying electricity.

The calculation unit is, on the other hand, configured for processing the active power value received from the local terminal 1, identifying the components of the powers absorbed by each device connected to the electric user device U as a function of the corresponding energy footprints.

Therefore, operatively, after receiving the active power signal produced by the local terminal 1, the remote terminal is able to disaggregate it by separating the contributions given by the individual devices on the basis of the respective energy footprints.

Advantageously, the local terminal may be or comprise a computing cloud, improving the accessibility and the efficiency of managing/storing the information of interest.

The remote terminal 2 may comprise or in general be configured for executing an artificial intelligence algorithm based on neural networks configured to disaggregate the active power value in such a way as to define a list of electrical consumptions associated with respective devices connected to the electric user device U.

In other words, the remote terminal 2 not only searches for the energy fingerprints but uses the automatic learning processes of the artificial intelligence algorithms to improve over time its capacity for analysing and discriminating individual devices, in such a way as to allow a precise list of the energy consumption associated with each of them to be provided in a unique manner.

This artificial intelligence algorithm may preferably be trained using a dataset D which comprises aggregated and disaggregated data.

In particular, the dataset D comprises aggregate input data 10 which correspond to active power values of at least one test electrical user T, whilst the disaggregated input data 20 corresponding to the electricity consumption of all the devices connected to the test electrical user T.

With this input dataset D the artificial intelligence algorithm is able to compile the database by associating with each device the respective energy footprint (derived from its disaggregated input data 20) and learn how each device affects the total active power of the user device.

Operatively, therefore, the artificial intelligence algorithm is configured to determine and store on the database energy fingerprints uniquely associated with respective devices as a function of the dataset Dt supplied to it. Preferably, the microcontroller 1c of the local terminal 1 is further configured to check a status of the connection with the remote terminal 2 at regular time intervals.

In this way it is possible to guarantee that the measurements performed are correctly processed allowing an accurate and reliable monitoring.

In the event of interruption of the connection between the local terminal 1 and the remote terminal 2 it is possible to generate an error signal, in particular the local terminal 1 is configured to generate the error signal.

The error signal can be of the acoustic and/or optical type and/or a signal which is transmitted to the remote terminal 2.

The system may further comprise a user interface 3 accessible by means of a personal terminal, such as, for example, a smartphone, a tablet, a computer. The user interface 3 is configured for displaying the active power components absorbed by each device connected to the electric user device U.

For this reason, the remote terminal 2 makes it possible to provide the user in real time, using the user interface 3, with the disaggregated consumption data of the various devices connected to the user.

Advantageously, the user interface 3 is also configured to receive and display the error signal, allowing the user to be alerted in a particularly fast manner if the connection between the local terminal 1 and the remote terminal 2 is interrupted and therefore allowing immediate recognition that the data received are no longer up to date.

Advantageously, the user interface 3 also allows the user to provide useful information by means of the relative personal terminal for the artificial intelligence algorithm.

In particular, the artificial intelligence algorithm can be trained by acquiring feedback input from the personal terminal.

For this reason, the input of the user supplements the dataset D provided for training the artificial intelligence algorithm in such a way as to be able to refine and/or correct the analysis capacity of the algorithm.

Advantageously, the invention achieves the preset aims overcoming the drawbacks of the prior art by providing the user with a system for monitoring electrical consumption which is able in particular to recognise in a precise and accurate manner the contributions to the consumption given by the individual devices connected to the electrical user U.

## Claims

1. A system for monitoring energy consumption comprising:
- a local terminal (1) comprising:
- a first sensor (1a) configured for measuring a total current dispensed to an electrical user device (U) generating a current signal;
- a second sensor (1b) configured for measuring a total voltage dispensed to said electrical user device (U) generating a voltage signal;
- a microcontroller (1c) configured for controlling the activation of said first and second sensors (1a, 1b) in such a way as to acquire continuously over time current and voltage signals and for calculating an active power signal of said electrical user device (U) as a function of said current and voltage signals;
- a remote terminal (2) connectable to the local terminal (1) for receiving the active power signal, said remote terminal (2) comprising:
- a database configured for storing a plurality of energy footprints representing an absorption of electricity uniquely associated with respective devices;
- a calculation unit configured for processing the active power value identifying active power components absorbed by each device connected to the electrical user device (U) as a function of the corresponding energy footprints.

2. The system according to claim 1, wherein the first sensor (1a) comprises an amperometric clamp.

3. The system according to claim 2, wherein the second sensor (1b) comprises a transformer for uncoupling and scaling the voltage.

4. The system according to any one of the preceding claims, wherein the microcontroller (1c) comprises an analysis module configured for filtering and amplifying the current and voltage signals.

5. The system according to any one of the preceding claims, wherein the remote terminal (2) is or comprises a computing cloud.

6. The system according to any one of the preceding claims, wherein the local terminal (1) and the remote terminal (2) are connected by a wireless connection, preferably a Wi-Fi^{®} protocol connection.

7. The system according to claim 6, wherein the microcontroller (1c) is configured for checking a status of the connection with the remote terminal (2) at regular time intervals.

8. The system according to claim 7, wherein the local terminal (1) is configured for generating an error signal if the connection with the remote terminal (2) is interrupted.

9. The system according to any one of the preceding claims, comprising a user interface (3) accessible using a personal terminal and configured for displaying said active power components absorbed by each device connected to the electrical user device (U).

10. The system according to claim 8 or 9, wherein the user interface (3) is configured for receiving and displaying the error signal.

11. The system according to any one of the preceding claims, wherein the remote terminal (2) comprises an artificial intelligence algorithm based on neural networks configured to disaggregate the active power value in such a way as to define a list of electrical consumptions associated with respective devices connected to the electric user device (U).

12. The system according to claim 11, wherein the artificial intelligence algorithm is trained by means of a dataset comprising:
- aggregate input data (10) corresponding to power values of at least one electrical test user (T);
- disaggregated input data (20) corresponding to the electricity consumption of all the devices connected to said electrical test user (T).

13. The system according to claim 11 or 12, wherein said artificial intelligence algorithm is configured for determining and storing on the database energy footprints uniquely associated with respective devices as a function of said dataset.

14. The system according to any one of claims 11 to 13 when dependent on claim 9, wherein the artificial intelligence algorithm can be trained by acquiring a feedback input which can be acquired using the user interface (3).
